# EUROPEAN PATENT SPECIFICATION

(11) **EP 0 320 471 B1**
(45) Date of publication and mention of the grant of the patent: **13.04.1994**
(21) Application number: 88830530.7
(22) Date of filing: 09.12.1988
(51) Int. Cl.: H03F 3/45

(54) **Common mode sensing and control in balanced amplifier chains**
Gleichtaktmessung und -regelung in Ketten von symmetrischen Verstärkern
Mesure et réglage de mode commun dans des chaînes d'amplificateurs symétriques

(30) Priority: 11.12.1987 IT 8368087
(43) Date of publication of application: 14.06.1989
(73) Proprietor: SGS-THOMSON MICROELECTRONICS s.r.l., 20041 Agrate Brianza (Milano) (IT)
(72) Inventor: Devecchi, Daniele, I-20033 Desio (IT); Torelli, Guido, I-27016 S. Alessio (IT)
(74) Representative: Pellegri, Alberto

(56) References cited:
- FR-A- 2 535 546
- US-A- 3 491 307
- IEEE TRANSACTIONS ON ACOUSTICS SPEECH AND SIGNAL PROCESSING, vol. ASSP-31, no. 1, part 2, February 1983, pages 305-312, IEEE, New York, US; R.K. HESTER et al.: "A monolithic data acquisition channel"
- IEEE JOURNAL OF SOLID-STATE CIRCUITS, vol. SC-17, no. 3, June 1982, pages 513-521, IEEE, New York, US; W.M.C. SANSEN: "On the integration of an internal human conditioning system"
- PROCEEDINGS OF THE IEEE 1985 CUSTOM INTEGRATEFD CIRCUITS CONFERENCE, Portland, Oregon, 20th-23rd May 1985, pages 174-177, IEEE; D.B. RIBNER et al.: "80 MHz low offset CMOS fully differential and single-ended OP AMPS"

## Description

### BACKGROUND OF THE INVENTION

### 1. Field of the invention

The present invention relates to balanced amplifiers, i.e. fully differential amplifiers, and the techniques for controlling the common mode voltage.

### 2. Discussion of the prior art

A fully differential or balanced amplifier is represented by a four terminal amplifying block, two input terminals (the inverting and the non-inverting input, respectively) and two output terminals (the positive and the negative output, respectively).

A characteristic of these amplifiers is that the usable output voltage isn't the voltage of a single output terminal referred to a common potential node of the circuit, but the potential difference between the two output terminals. Although the value of the voltage between each output terminal and the circuit ground isn't significative in relation to the useful output signal of the amplifier, such a voltage is all the same subject to certain restraints, often rather stringent, in order to ensure a correct operation of the whole circuit. In fact, an anomalously different value from the design value of the voltages toward ground of the two output terminals of an amplifier may compromise the correct biasing of the input devices of a following stage as well as the correct biasing of the output transistors themselves of the amplifiers.

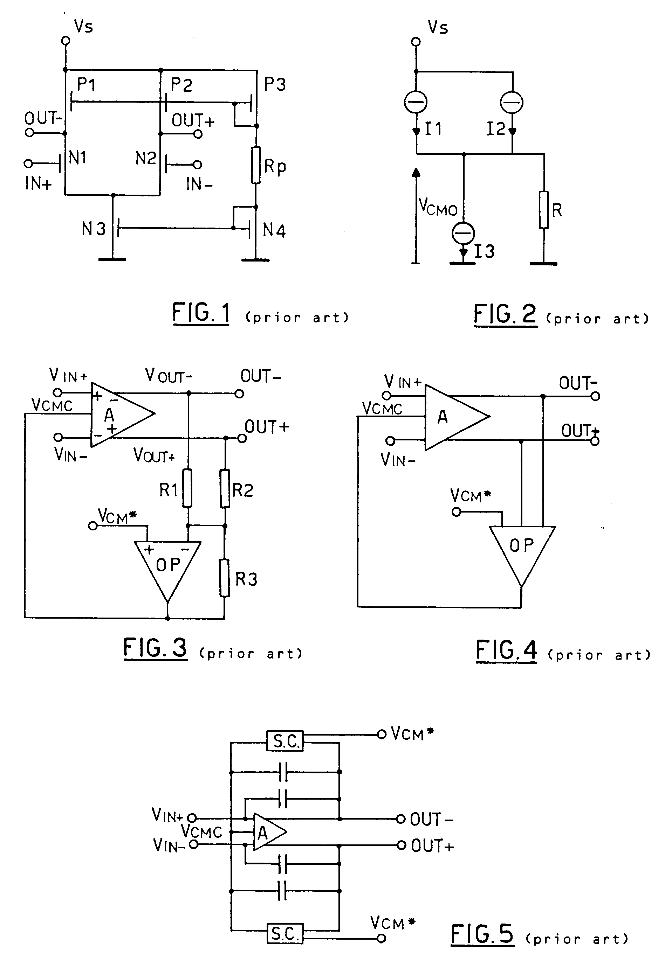

The terms of the problem may be better understood by referring to Fig. 1, wherein a most elementary type of balanced amplifier made with CMOS devices is depicted. The amplifier is formed by a pair of input transistors N1 and N2, by three current generators formed by transistors P1, P2 and by the transistor N3, respectively. The gates of the input transistors constitute the two input terminals IN+ and IN- of the differential amplifier and the drains of the same transistors constitute the respective nodes or output terminals OUT- and OUT+. A network for controlling the biasing currents of the differential input pair of transistors N1 and N2 is formed by two diode connected transistors P3 and N4 and by the control resistor Rp. The operation of the circuit is of immediate comprehension by a skilled technician and hardly requires further explanations. In such an amplifier the input voltage will be:

$\text{Vi = Vin+ - Vin-}$

while the output voltage will be:

$\text{Vout = Vout+ - Vout-}$

and it is defined as "input common mode voltage":

$\text{Vcmi = 1/2 (Vin+ + Vin-)}$

and it is defined as "output common mode voltage":

$\text{Vcmo = 1/2 (Vout+ + Vout-).}$

In order for the amplifier of Fig. 1 to work and be able to drive a similar following amplifier stage, it is necessary for the Vcmo to be comprised within a voltage range, the limits of which depend upon the desired output signal swing and other parameters, which are often tied to the fabrication technology of the semiconductor devices (e.g. the threshold voltages of transistors) as well as the supply voltage (Vs) of the circuit.

A correct operation of the amplifier is ensured when all transistors operate within the so-called "saturation zone". In this case the amplifier's circuit of Fig. 1 may be schematically depicted, in terms of the output common mode voltage,as shown in the circuit diagram of Fig.2, wherein the transistors used as current generators are represented by means of the relative current generator symbol and the presence of a resistor R signifies the non-ideality of current generators (finite impedance) and consequently the channel modulation effect of the transistors forming the differential amplifier.

It is evident that:

$\text{Vcmo = R (I1 + I2 - I3).}$

It would appear simple to determine a suitable value of the output common mode voltage of the amplifier (Vcmo) by controlling the value of the resistor R and the values of the currents I1, I2, I3.

In practice this isn't possible because R is hardly controllable in a sufficiently precise manner and in any case the value of such a resistance R must be rather high in order to obtain a sufficiently high differential gain. The currents I1 and I2 (the two respective current generaotrs) must be as identical as possible in order to reduce the "offset" voltage of the amplifier. In practice the parameter which would appear simpler to act on is the value of the current I3, which is also hardly controllable with a sufficient precision to ensure a desired value of the output common mode voltage Vcmo.

It is therefore common to adjust the value of the Vcmo by additional circuit means which essentially consist of feedback loops, commonly referred to as "common mode feedbacks". This output common mode voltage control loop of the amplifier may be implemented within the integrated amplifier itself or by external means, but in any case the problem exists of discriminating the common mode signal from the differential signal. This,especially when the dynamic range of the output signal is of the same order of the Vcmo, may originate other problems as for example a transfer of the differential signal on the common mode signal, as will be described later.

A classic solution of the problem is depicted in Fig. 3. The balanced amplifier, the output common mode voltage of which must be controlled, is indicated by the simbol A. The output common mode voltage control loop is formed by a single- ended operational amplifier,indicated by the simbol OP, connected in a summing network, which comprises the resistances R1, R2 e R3, and capable to generate an output voltage (commonly referred to as error signal) which is proportional to:

$\text{Vout+ + Vout- - Vcm*}$

where Vcm* is the desired design value of the output common mode voltage Vcmo of the amplifier. Such an output voltage of the OP amplifier is used, according to techniques known to the skilled technician, by applying it to a dedicated Vcmc terminal of the balanced amplifier ( output common mode control terminal) in order to control the value of the current I3, or of the currents I2 and I2 (Fig. 2), in such a way as to keep the Vcmo of the fully differential amplifier A within a correct range set by such a a reference voltage Vcm*. This type of solution is hardly convenient because it utilizes resistors, i.e. components which when made in CMOS technology generally have a large area requirement and become the origin of non-linearity phenomena causing a "contamination" by the differential mode of the common mode, furthermore such a solution is only applicable to amplifiers having an output impedance sufficiently low to drive such resistors, which isn't always possible in case of amplifiers intended for operation in switched capacitor type circuits which often have a high output impedance and a limited ability to deliver current. In any case such a solution is often difficult to implement and implies remarkable complications.

An example of a common mode control system of this type is described and shown in Fig. 1 of US-A-3,491,307.

A second known solution which doesn't require the utilisation of resistors, uses a three input operational amplifier (OP), as depicted in Fig. 4. Two of the three inputs of the feedback amplifier OP sum the Vout+ e Vout-signals, while the third input acts differentially in respect to the other inputs by comparing these inputs with a reference voltage Vcm*. This solution, though not using resistors, uses a circuit which again presents the problem of contamination between the differential mode and the common mode though avoiding to sensibly load the stage to which it is applied (i.e. the balanced amplifier A). Moreover the design of such a three input amplifier OP may entail remarkable problems because the input stage transistors of such a three input amplifier sum the signals applied to the input terminals under a bias condition which doesn't easily permit an exact cancellation of the positive signal by the negative signal.

A third known solution, which is conceptually similar to the first described in Fig. 3, is depicted in Fig. 5. The summing network of resistors is substituted with an analog summing network of switched capacitors (S.C.) and furthermore, by utilising two identical networks on both "channels" of the balanced amplifier A, it is possible to completely eliminte the requirement of an auxiliary operational amplifier for stabilisation by accepting a further increase of the capacitive load of the balanced amplifier A. In many circuit situations such a solution may present a common mode "offset" voltage which is rather high in respect to the desired value Vcm*.

On the other hand, most often such balanced (fully differential) amplifiers are used in cascade, the chain of the balanced amplifiers comprising at least two but more commonly a rather large number of cascaded amplifiers, as for example in the case of switched capacitor integrator chains. In this instance the problem of controlling the output common mode voltage is manifolded.

### OBJECTIVES AND SUMMARY OF THE INVENTION

A main objective of the present invention is to provide an output common mode voltage control system for fully differential (balanced) amplifiers connected in cascade which is less problematic and simpler to implement than the known system.

The solution proposed herein contemplates the utilisation of the characteristics of the input differential pair of transistors of a differential amplifier of the chain for sensing the output common mode voltage Vcmo of the differential amplifier which "precedes" said amplifier in the chain. In practice, on the input gates of an operational amplifier, besides the input signal voltage, also the output common voltage Vcmo of the amplifier which precedes the amplifier in the chain of cascaded amplifiers is applied and, notwithstanding the fact that the output terminals of a good quality fully differential amplifier shouldn't be affected therefrom, in other words notwithstanding the fact that the CMRR (Common Mode Rejection Ratio) should be as high as possible, this output common mode voltage of the preceding amplifying stage is surely affecting at least the potential of the two sources connected in common of the input differential pair of transistors. From this circuit node such a Vcmo voltage of the preceding stage may be easily sensed and made available through a dedicated terminal. Therefore the sensing of the value of the output common mode voltage of a balanced amplifier is performed by utilising components which are already present in the circuit for other purposes without interferring in an appreciable way with the original function thereof (i.e. by utilising the input differential pair of transistors of the amplifier which is connected in cascade to the amplifier, the output common mode voltage of which must be controlled).

This offers immediately the first and fundamental advantage in respect to the known systems, represented by the fact that the sensing of the output common mode takes place without loading in any way the output of the amplifier to be stabilized.

### BRIEF DESCRIPTION OF THE DRAWINGS

Figures 1, 2, 3, 4 and 5 are circuit diagrams used for illustrating the addressed technical problem and several known solutions thereof in accordance with the prior art, as described above;
Fig. 6 is a basic circuit diagram illustrating the output common mode control system of the present invention applicable to a chain of cascaded fully differential amplifiers.

### DESCRIPTION OF THE PREFERRED EMBODIMENT

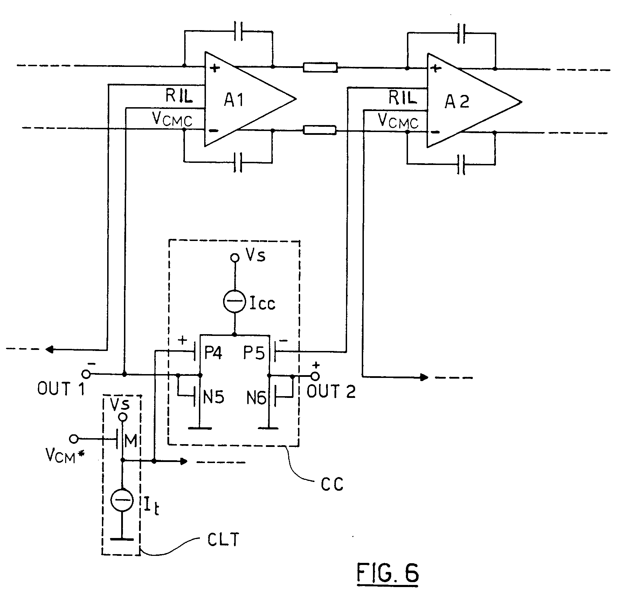

A Cmos embodiment of the system of the invention is illustraded in Fig. 6.

In Fig. 6 two balanced (fully differential) Cmos amplifiers A1 and A2 are shown, the amplifier A2 being connected in cascade to the amplifier A1. The two amplifiers shown may be representative of a chain of balanced amplifiers formed by an arbitrarily large number of cascaded amplifiers. Each amplifier is provided with an output common voltage control terminal Vcmc, in accordance with commonly known techniques.

Each amplifier of the chain is further provided with an additional terminal RIL which is essentially connected to the circuit node of the common connected sources of the input differential pair of transistors of the amplifier.

As it is known, the gain of an operational amplifier is extremely high thus the signal effectively present at the inputs of an operational amplifier which is part of a closed loop circuit is relatively very small and furthermore balanced, i.e. $\text{Vin+ ≅ - Vin-}$ 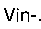 . Therefore the voltage present on the source of the two input differential pair of transistors of an amplifier essentially doesn't depend from the applied signal but practically depends exclusively from the value of the input common mode voltage (Vcmi) and will follow exclusively the variation of such a voltage less a certain threshold voltage (Vt) of the transistors consituting the input differential pair of the amplifier. On the source common node of such a pair of input transistors is therefore available an exact replica of the ouput common mode voltage (Vcmo) of the preceding amplifier of the chain, less the threshold voltage (Vt) of the transistors.

In other words,on the RIL terminal of the amplifier A2 there will be available a voltage replica of the output common mode voltage Vcmo of the preceding amplifier A1.

By means of a comparator circuit CC, formed substantially by a differential input amplifier, it is possible to compare the voltage signal available on the RIL terminal of the amplifier A2 and corresponding to: Vcmo_{A1} - Vt, with a reference signal corresponding: Vcm* - Vt,thus obtaining at the output OUT1 or at the output OUT2 of the comparative circuit CC an "error signal" of the output common mode voltage of the amplifier A1. Such a signal is then applied to the control terminal Vcmc of the output common mode voltage of the amplifier A1 in order to stabilize the output common mode voltage at a desired value which is set by the reference voltage Vcm* which is applied to a level shifting circuit CLT which may conveniently be unique for all the control loops of the output common mode voltage of the amplifiers of the chain.

As shown in Fig. 6, the comparator circuit CC may be formed by a differential pair of P-channel transistors, P4 and P5, the gates of which represent a noninverting and an inverting input terminal, respectively, of the comparator circuit; by the relative current generators formed by the two n-channel transistors N5 and N6 and by the current generator Icc. The voltage signal available on the RIL terminal of the amplifier A2 is applied to the inverting (-) input terminal of the comparator circuit CC, while to the noninverting (+) input terminal thereof a voltage replica of the reference voltage Vcm* is applied by means of the level shifting circuit CLT. The latter is shown being formed by a current generator It and by a MOS transistor M which has necessarily the same polarity of the MOS transistors forming the input differential pair of the amplifier A2, on which the output common mode voltage of the amplifier A1 is sensed.

The embodiment depicted in Fig. 6 shows two distinct outputs, namely a positive and a negative output, of the comparator circuit CC. Case by case,only one of these outputs (-) OUT1 and (+) OUT2 will be utilized, respectively, in case the gain between the common mode control terminal and the output terminal is positive or negative, in order to implement a negative feedback capable of stabilizing the system. In the shown embodiment it is assumed that the output common mode control terminal Vcmc of the amplifier A1 is an inverting type terminal in respect to the output common mode and consequently the negative output OUT2 of the comparator circuit CC is shown as being connected to the control terminal Vcmc of the amplifier A1.

The embodiment of Fig. 6 is extremely simple and particularly efficient when the control input terminal Vcmc is connected to the gate of a MOS transistor operating as a current generator of the same type of the ouput MOS transistor of the comparator circuit CC because in this case the circuit operates essentially as a current mirror. In such a case it is particularly simple to size the current generator Icc and the transconductance of the comparator circuit CC in function of the known parameters of the balanced amplifier to be stabilized in order to obtain the desired degree of control over the output common mode voltage Vcmo thereof.

Of course all the amplifiers of the chain with the exception of the last one may be so stabilized by means of the system of the invention. The last amplifier of the chain may also be stabilized with the same system of the present invention by purposely providing a further suitable differential stage cascaded to the output of said last amplifier onto which sensing the output common mode of the last balanced amplifier of the chain in order to implement the described stabilizing feedback. Otherwise such a last amplifier of the chain may also be stabilized by means of anyone of the techniques of the prior art which have been described previously.

In comparison to the known systems for sensing and controlling the output common mode voltage of balanced amplifiers, the solution proposed by the applicants offers important advantages:
- the load on the outputs of the amplifier to be stabilized is not increased;
- the operational amplifier required for comparing the sensed Vcmo and the reference voltage Vcm* may be extremely simple;
- a portion of the control circuit, i.e. the level shifting circuit CLT, may be conveniently common for all the balanced amplifiers of the chain to be stabilized ;
- the implementation of the common mode control system of the invention doesn't require generally additional components for the frequency compensation of the stabilized amplifiers.

Although the control circuit of the invention is particularly suited to be made in CMOS technology it may also be easily implemented in an N-channel or in a P-channel technology as well as in bipolar technology.

Whenever the balanced amplifiers, the Vcmo of which must be controlled, are to function in a circuits comprising resistor networks or resistor simulating networks such as for example switched capacitor networks connected between the outputs of an amplifier and the inputs of the same amplifier, the Vcmi voltage of an amplifier will not depend exclusively from the Vcmo voltage of the preceding amplifier in the chain but, to some extent, also from the Vcmo voltage of the amplifier itself. In this case the utilization of the system of the invention may be considered case by case in function of such peculiarities of the overall circuit.

## Claims

1. A chain of fully differential amplifiers comprising:
at least two amplifiers (A1, A2) connected in cascade, each amplifier of the chain comprising an input differential pair of transistors each having a gate connected, respectively, to a first and a second input terminal of the amplifier, the respective sources of said transistors being connected in common; wherein at least the first or preceding one of said at least two cascaded amplifiers has two output terminals cascadedly connected to the following amplifier in the chain;
means for sensing the output common mode voltage of said first or preceding amplifier;
means for comparing the sensed output common mode voltage of said first or preceding amplifier with a preset reference voltage and for generating an error voltage signal proportional to the difference between said sensed output common mode voltage and said preset reference voltage; and
means for maintaining said output common mode voltage of said first or preceding amplifier below a maximum value set by said reference voltage by applying said error signal to an output common mode voltage control terminal (V_{CMC}) of said first or preceding amplifier (A1);
characterized in that
said sensing means, said comparing means and said means for applying said error signal comprise an electrical connection (RIL) between said commonly connected sources of said input differential pair of transistors of said amplifier (A2) which follows said first or preceding amplifier (A1) in the chain of cascaded amplifiers and a first input terminal of a differential input comparator (CC) having a second input terminal to which said preset reference voltage is applied by means of a level shifting circuit (CLT), and
an electrical connection between an output (OUT1) of said differential input comparator (CC) and said output common mode voltage control terminal (V_{CMC}) of said first or preceding amplifier (A1).

## Patentansprüche

1. Kette aus Voll-Differenzverstärkern, umfassend:
mindestens zwei Verstärker (A1, A2), die in Kaskade geschaltet sind, wobei jeder Verstärker der Kette ein Eingangs-Differenzpaar von Transistoren aufweist, die jeweils mit einen Gate an einen ersten bzw. einem zweiten Eingangsanschluß des Verstärkers angeschlossen sind, und die jeweiligen Sources der Transistoren zusammengeschaltet sind; wobei mindestens der erste oder vorausgehende der mindestens zweiten in Kaskade geschalteten Verstärker zwei Ausgangsanschlüsse aufweist, die kaskadeähnlich an den nachfolgenden Verstärker innerhalb der Kette angeschlossen sind;
eine Einrichtung zum Erfassen der Ausgangs-Gleichtaktspannung des ersten oder des vorausgehenden Verstärkers;
eine Einrichtung zum Vergleichen der erfaßten Ausgangs-Gleichtaktspannung des ersten oder vorausgehenden Verstärkers mit einer voreingestellten Referenzspannung, um ein Fehlerspannungssignal zu erzeugen, welches proportional ist zu der Differenz zwischen der erfaßten Ausgangs-Gleichtaktspannung und der voreingestellten Referenzspannung; und
eine Einrichtung zum Halten der Ausgangs-Gleichtaktspannung des ersten oder vorausgehenden Verstärkers unterhalb einem Maximalwert, welcher durch die Referenzspannung eingestellt wird, indem das Fehlersignal an einen Ausgangs-Gleichtaktspannungs-Steueranschluß (Vcmc) des ersten oder vorausgehenden Verstärkers (A1) gelegt wird;
dadurch gekennzeichnet, daß
die Erfassungseinrichtung, die Vergleichereinrichtung und die Einrichtung zum Anlegen des Fehlersignals eine elektrische Verbindung (RIL) zwischen den zusammengeschalteten Sources der zu dem Eingangs-Differenzpaar gehörigen Transistoren des Verstärkers (A2), welcher dem ersten oder vorausgehenden Verstärker (A1) in der Kette kaskadierter Verstärker folgt, und einem ersten Eingangsanschluß eines Differenzeingangsvergleichers (CC), der einen zweiten Eingangsanschluß aufweist, dem die voreingestellte Referenzspannung mittels einer Pegelverschiebeschaltung (CLT) zugeführt wird, aufweist, und
eine elektrische Verbindung vorgesehen ist zwischen einem Ausgang (OUT1) des Differenzeingangsgleichers (CC) und dem Ausgangs-Gegentaktspannungs-Steueranschluß (V_{CMC}) des ersten oder vorausgehenden Verstärkers (A1).

## Revendications

1. Chaîne d'amplificateurs à entrées et sorties différentielles comprenant :
au moins deux amplificateurs (A1, A2) connectés en cascade, chaque amplificateur de la chaîne comprenant une paire différentielle de transistors d'entrée ayant chacun une grille connectée, respectivement, à une première et à une seconde borne d'entrée de l'amplificateur, les sources respectives des transistors étant connectées ensemble, dans lesquels au moins le premier ou le précédent desdits au moins deux amplificateurs en cascade comprend deux bornes de sortie connectées en cascade à l'amplificateur suivant de la chaîne ;
des moyens pour détecter la tension de mode commun de sortie du premier amplificateur ou amplificateur précédent ;
des moyens pour comparer la tension en mode commun de sortie détectée du premier amplificateur ou amplificateur précédent à une tension de référence prédéterminée et produire un signal de tension d'erreur proportionnel à la différence entre la tension de mode commun de sortie détectée et la tension de référence prédéterminée ; et
des moyens pour maintenir la tension de mode commun de sortie du premier amplificateur ou amplificateur précédent en dessous d'une valeur maximale établie par la tension de référence à une borne de commande de tension de mode commun de sortie (V_{CMC}) du premier amplificateur ou amplificateur précédent (A1);
caractérisée en ce que
les moyens de détection, les moyens de comparaison et les moyens pour appliquer le signal d'erreur comprennent une connexion électrique (RIL) entre les sources connectées ensemble de la paire différentielle de transistors d'entrée dudit amplificateur (A2) qui suit le premier amplificateur ou amplificateur précédent (A1) dans la chaîne d'amplificateurs en cascade et une première borne d'entrée d'un comparateur différentiel (CC) ayant une seconde borne d'entrée à laquelle la tension de référence prédéterminée est appliquée par un circuit de décalage de niveau (CLT), et
une connexion électrique entre une sortie (OUT1) du comparateur différentiel d'entrée (CC) et la borne de commande de tension en mode commun de sortie (V_{CMC}) du premier amplificateur ou amplificateur précédent (A1).
